# EUROPEAN PATENT APPLICATION

(11) **EP 4 324 961 A1**
(43) Date of publication of application: **21.02.2024**
(21) Application number: 22190748.8
(22) Date of filing: 17.08.2022
(51) Int. Cl.: C30B 23/02, C30B 29/36

(54) **METHOD FOR PRODUCING A BULK SIC SINGLE CRYSTAL WITH IMPROVED QUALITY USING A SIC SEED CRYSTAL WITH A TEMPORARY PROTECTIVE OXIDE LAYER, AND SIC SEED CRYSTAL WITH PROTECTIVE OXIDE LAYER**

(71) Applicant: SiCrystal GmbH, 90411 Nürnberg (DE)
(72) Inventor: ECKER, Bernhard, 90491 Nürnberg (DE); MÜLLER, Ralf, 90513 Zirndorf (DE); SCHUH, Philipp, 90587 Veitsbronn (DE); STOCKMEIER, Matthias, 91349 Egloffstein (DE)
(74) Representative: Grünecker Patent- und Rechtsanwälte PartG mbB

(57) **Abstract**

The present invention relates to a silicon carbide substrate for use as a crystal seed, comprising a monocrystalline silicon carbide disk covered with a protective oxide layer. The protective oxide layer is intended to be removed to expose an ideal, clean surface of the monocrystalline silicon carbide disk. The present invention also relates to a method of producing at least one bulk silicon carbide single-crystal by sublimation growth using the silicon carbide substrate with protective oxide layer as a seed crystal. The protective oxide layer is removed from the seed crystal surface to expose the underlying monocrystalline silicon carbide disk by a back-etching process performed in-situ in the crystal growth crucible, i.e. after the seed crystal is arranged inside the growth crucible and before the sublimation deposition on the growth surface starts.

## Description

### TECHNICAL FIELD OF THE INVENTION

The present invention relates to a silicon carbide (SiC) seed crystal having a protective oxide layer that is to be used as a seed crystal in a sublimation process, and a method for producing a bulk SiC single crystal with improved quality using the SiC seed crystal.

### BACKGROUND OF THE INVENTION

Silicon carbide (SiC) substrates are generally used in the semiconductor industry, such as in the production of semiconductor and electronic devices. Conventionally, SiC substrates are fabricated from a bulk SiC single crystal (also called ingot) which is sliced using multi-wire sawing or other suitable cutting process, such as laser-assisted cutting, to yield a plurality of SiC substrates. The surface(s) of the SiC substrates are then processed in multi-stage polishing steps in preparation for the subsequent epitaxial processes during which monocrystalline layers of materials, such as SiC or GaN, are deposited onto the polished SiC substrates. The physical properties of such monocrystalline layers and the devices fabricated therefrom will depend critically on the quality of the underlying SiC substrate and therefore, also on the quality of the original bulk SiC single crystal itself.

Bulk SiC single crystals are generally grown by physical vapor deposition (PVT) from suitable sublimation source materials and seed crystals. For instance, a physical vapor deposition (PVT) process for producing bulk SiC crystals is disclosed in US 8,865,324 which uses a monocrystalline SiC disk as a seed for growing the bulk single crystal. A monocrystalline SiC seed is arranged together with a suitable source material in a crucible of a PVT growth system. Under controlled temperature and pressure conditions, the source material is sublimed and the resultant sublimated material directed towards the SiC seed under the effect of appropriate thermal gradients to deposit onto the SiC seed for growing the crystal.

It should be noted that in the present disclosure the following terms will be used to discern between different components. Firstly, the SiC starting material, which is to be mounted inside a crucible and on which the sublimated source material is growing, will be referred to as a "seed crystal" or "seed". In the present disclosure, this seed crystal comprises a single crystal disk with a growth surface on which SiC is deposited in a sublimation process. Further, the grown single crystal is referred to as "bulk crystal", "bulk silicon carbide single-crystal", "ingot", or "single crystal boule". By slicing the bulk crystal, so-called "substrates" are obtained. These substrates are used by integrated circuit manufacturers to grow thereon epitaxial layers and to fabricate so-called "wafers" which in the following are considered to comprise semiconductor structures. By dicing the wafer, individual "dies", also called "chips", are produced.

The condition and quality of the SiC seed, and in particular of the deposition surface, is a major factor for the final quality of the crystal grown thereon. In particular, various types of impurities, such as contaminating atoms, particles and dirt, may fall and attach to the surface of the SiC seed during polishing processing and/or handling of the seed after polishing processing. These surface impurities promote the generation of various types of defects in the bulk crystal grown on the seed which degrades the quality of the crystals grown thereon. For instance, impurity atoms, molecules, and/or clusters deposited on the seed surface will act as starting points of dislocations on the growing crystal, such as threading screw dislocations (TSD) and threading edge dislocations (TED), which continue to develop into the bulk crystal during the growth process. Such dislocations negatively affect the quality of grown bulk crystals, of the SiC substrates produced therefrom, and finally the epitaxial quality of the monocrystalline layer(s) to be grown onto such SiC substrates.

Additionally, particles (for e.g. of silicon, carbon, and SiC) that remain stuck to the surface of the SiC seed after seed handling may overgrow during the crystal growth process, leading to generation of defects known as inclusions or, depending on their size, also create dislocations or microtubes in the growing crystal. Furthermore, deposited impurities and particles from materials/elements other than SiC may even lead to a polytype change of the growing bulk crystal (for e.g. a change of the crystal structure from 4H to 6H or 15R), depending on the chemical composition of the impurity.

All the above-mentioned defects lead to a decrease in quality and yield of the grown bulk crystals and SiC substrates, resulting in decrease quality of the epi-layers produced onto such SiC substrates and the electronic components produced therefrom.

So far it has been attempted to improve the quality of the bulk crystal grown onto a seed crystal by taking into account that impurities will accumulate onto the surface of the seed crystal, namely, during polishing processing of the seed and/or handling of the seed after processing is done.

For instance, JP 2008 024 554 describes a method for improving the quality of crystals grown onto a monocrystalline SiC seed. According to this method, dislocations in the monocrystalline SiC crystal are exposed by selective etching and then overgrown with an oxide layer and a protective film. Subsequently, ex-situ anisotropic back-etching is performed, thereby exposing the original monocrystalline seed surface together with the filled etch pits. The dislocations originally present in the seed crystal should then be no longer able to progress into a crystal to be later grown thereon in a subsequent growth process. However, this method aims at reducing the effects of dislocations formed in the seed but not eliminate the cause for the formation of such defects, i.e. it does not prevent that impurity atoms and particles accumulate on the surface of the seed during the various handling processes of the seed (for e.g., during installation of the seed inside the growth crucible) prior to starting the actual crystal growth process, i. e. starting the deposition of SiC on the seed growth surface. As a result, the deposition of impurities on the surface of a SiC seed processed using this technique may still occur during handling of the seed and therefore, lead to the formation of further defects in the crystal to be grown thereon, such as the generation of new dislocations, and/or cause a polytype change of the SiC crystal structure. In particular, a correct transmission of polytype information from the seed crystal to the crystal to be grown thereon is an essential prerequisite for polytypic growth of monocrystalline SiC crystals. However, a SiC seed with a non-polytypic surface, such as the one produced according to the disclosure of JP 2008 024 554, which contains areas with SiO₂ or other oxides to seal the etch pits, favors polytype changes during crystal growth, rendering the grown crystal unusable and thus reducing yield.

Thus, there is still a need for techniques that allow to improve the quality and yield of bulk SiC single crystals and monocrystalline SiC substrates by reducing one of the major causes for the generation of defects and/or polytype changes on the bulk SiC crystals and monocrystalline SiC layers, which is the presence of impurities and contaminating particles at the surface of the SiC seed crystal prior to the actual crystal growth process, in particular the deposition of SiC on the seed growth surface.

### SUMMARY OF THE INVENTION

The present invention has been made in view of the shortcomings and disadvantages of the prior art, and an object thereof is to provide a monocrystalline silicon carbide (SiC) seed crystal with a reduced amount of impurities and contamination particles prior to the deposition of SiC on the seed growth surface, and a method for producing a bulk SiC single crystal with improved quality using the monocrystalline silicon carbide (SiC) seed.

This object is solved by the subject matter of the independent claims. Advantageous embodiments of the present invention are subject matter of the dependent claims.

According to the present invention, there is provided a silicon carbide seed crystal, comprising: a monocrystalline silicon carbide disk; and a protective oxide layer covering an area of a first face of the monocrystalline silicon carbide disk. The first face is the growth surface in the volume crystal growth process. Further, the protective oxide layer is characterized by having a thickness variation along the covered area that is of less than a predetermined tolerance value, above and below, from a mean thickness of the protective oxide layer.

Thus, the ideal properties of the monocrystalline SiC disk, in particular the growth surface, are protected by the oxide layer against the deposition of a new defect sources, such as dirt, particles, impurity atoms, during further handling operations of the silicon carbide disk to be used as a seed crystal, such as the attachment of the seed crystal to a holder for inserting and holding the seed crystal into a growth crucible. The oxide layer remains on the seed until shortly before the start of the SiC deposition process but at least until after the intended installation in the growth crucible. The growth surface is for instance the (000-1) plane for 4H crystal growth, or the (0001) plane for 6H crystal growth. Also other orientations and lattice planes are intended to be included by the present disclosure.

According to a further development, the mean thickness is an average of the protective oxide layer thicknesses over the entire area covered by the protective oxide layer; and/or the mean thickness of said protective oxide layer is from 5 nm to 20 nm.

According to a further development, the protective oxide layer is composed of silicon dioxide and has a mean thickness of 1 nm to 25 nm, the predetermined tolerance value is 0.5 nm so that the thickness of the protective oxide layer at any position of the covered area of the first face does not deviate by more than 0.5 nm, above or below, the mean thickness of the protective oxide layer.

According to a further development, the deviation of the thickness of the protective oxide layer is not more than 0.3nm, above or below, the mean thickness.

According to a further development, the first face covered by the protective oxide layer corresponds to a volume crystal growth surface (e. g. the C-face for 4H crystal growth) of the monocrystalline silicon carbide disk; and/or the monocrystalline silicon carbide disk has a thickness between 500µm and 5000µm, or between 800µm and 3000µm; and/or the silicon carbide disk has a diameter greater than or equal to 150 mm, preferably greater than or equal to 200 mm.

According to a further development, the first face of the monocrystalline silicon carbide disk has a surface roughness between 0.5 nm and 1nm in the direction of the monocrystalline silicon carbide disk thickness.

According to a further development, the monocrystalline silicon carbide disk is made of one of the 4H-, 6H-, 15R-, and 3C-modifications of silicon carbide, preferably pf the 4H-SiC modification; and/or the monocrystalline silicon carbide disk has an off-axis orientation characterized by an off-axis angle between 0 and 4°, preferably an 0-2° off-axis orientation.

According to a further development, the first face of the monocrystalline silicon carbide disk has: an etch pit density of less than 12000/cm², preferably less than 8000/cm²; and/or a screw dislocation density of less than 2000/cm², preferably less than 1000/cm².

The present invention also provides a method of producing at least one bulk silicon carbide single-crystal by sublimation growth inside a growth crucible having at least one crystal growth region for arranging at least one seed crystal inside and a source material region in which powdered or partly compacted silicon carbide material is stored for sublimation, the method comprising steps of: providing at least one silicon carbide seed crystal with a protective oxide layer according to the present invention to be used as the at least one seed crystal; fixing the at least one seed crystal to a holding device and inserting the seed crystal fixed to the holding device into the growth region of the growth crucible; enclosing the growth crucible with a thermal insulation material; performing a sublimation growth process during which the source material is sublimated from the source material region and the sublimated gaseous material transported into the crystal growth region to generate a silicon carbide growth gas phase in the crystal growth region from which a bulk silicon carbide single-crystal is grown onto the seed crystal arranged therein by deposition from the SiC growth gas phase; characterized in that after the at least one seed crystal with the protective oxide layer is arranged in the crystal growth region and before starting the sublimation growth process, performing a back-etching process in the crystal growth region that is adapted to remove the protective oxide layer from the surface of the seed crystal and expose the underlying monocrystalline silicon carbide disk.

Thus, the production process is designed in such a way that before the start of the growth process, e.g. by setting an appropriate silicon and carbon vapor pressure in the growth chamber, the protective oxide layer is removed *in-situ* from the SiC substrate, thereby exposing the underlying face of the monocrystalline SiC seed free of impurities, particles and impurity atoms. As a result, subsequent crystal growth can be initiated on the ideal seed surface, and a crystal with high quality can be produced.

According to a further development, said step of providing at least one silicon carbide seed crystal with a protective oxide layer includes: performing an oxidation process onto a monocrystalline silicon carbide disk for covering said area on the first face with an oxide layer, wherein the oxidation process is performed prior to fixing the silicon carbide substrate to a holding device and inserting the silicon carbide substrate fixed to the holding device into the growth region of the growth crucible.

According to a further development, the at least one silicon carbide seed crystal used as crystal seed is provided with the first face corresponding to the growth surface of the monocrystalline silicon carbide disk; and/or the growth crucible used in the producing method is partly formed of graphite.

According to a further development, the back-etching process comprises: supplying a gaseous atmosphere of back-etching components to the crystal growth region in the growth crucible, and setting a given vapor pressure of the back-etching gaseous atmosphere that is selected to etch away the protective oxide layer, wherein the back-etching components comprise silicon and/or carbon; and maintaining the back-etching process for a time duration that depends on the thickness of the protective oxide layer such as to entirely expose the area of the first face covered by the protective oxide layer. Alternatively, the back-etching is performed as a mere thermal etching process, in which no additional back-etching components are added, but an elevated temperature and a vacuum process are used for removing the protective oxide layer.

According to a further development, the back-etching process is performed under one of the following conditions or a combination thereof: (i) at a pressure between 0.1 mbar and 100 mbar; (ii) during a high vacuum process step at a pressure in the range of 1×10⁻⁷ mbar to 1×10⁻³ mbar; (iii) during a purging process step with an inert gas; and (iv) by using a reducing gas selected from a group of reducing gases that include SF₆, Cb, CHF₃, C₂F₆, NF₃, CF₄, or mixtures thereof in the growth crucible.

According to a further development, the back-etching process is performed under one of the following temperature conditions: at a temperature above 1200°C and below the sublimation temperature of the source material, preferably below 1400°C; and at a temperature above 1650°C and below the sublimation temperature of the source material, preferably below 1850°C.

According to a further development, the oxidation process includes one of the following or a combination thereof: dry oxidation with oxygen and optionally an inert gas, the inert gas including nitrogen and/or argon; wet oxidation with a mixture of oxygen and water and optionally an inert gas; oxidation at a temperature between 15°C and 50°C (for instance 40°C) in a defined gas atmosphere; oxidation by ozone; oxidation by oxygen plasma; and/or oxidation with at least one of Na₂CO₃, H₂O₂, NaOH, KIO₃, KCIO₃, KMnO₄, and CrO₃.

Overall, with the SiC seed crystal and method of producing bulk SiC single-crystals using the same according to the present invention, bulk SiC single-crystals of higher quality can be produced due to the use of the SiC seed crystal with a temporary protective oxide layer that is only removed *in-situ* after the seed crystal has been introduced into the growth crucible and prior to starting the actual sublimation growth This allows for a substantial improvement of the bulk crystal quality due to the surface of the seed crystal exposed by back-etching displaying a reduced amount of impurities and contamination particles. Thus, the formation of bulk crystal defects, such as dislocation, inclusions and/or even changes in the SiC crystal structure, will no longer occur or at least be significantly reduced, in comparison to conventionally produced bulk SiC single crystals. Thus, the bulk SiC single crystals produced according to the invention offer a higher quality and therefore, allow to increase yield and quality of the SiC wafers and semiconductor components produced therefrom.

The accompanying drawings are incorporated into and form a part of the specification for the purpose of explaining the principles of the invention. The drawings are not to be construed as limiting the invention to only the illustrated and described examples of how the invention can be made and used.

### BRIEF DESCRIPTION OF THE FIGURES

Further features and advantages will become apparent from the following and more detailed description of the invention as illustrated in the accompanying drawings, in which:
**Fig. 1** is a diagrammatic, cross-sectional view of a SiC seed crystal with a temporary protective oxide layer according to the present invention;
**Fig. 2** is a diagrammatic, cross-sectional view of the SiC seed crystal according to the present invention, fixed to a holding device and depicting the accumulation of impurities on the surface of the protective oxide layer;
**Fig. 3** shows a diagrammatic, cross-sectional view of a growth arrangement for producing a bulk SiC single crystal by sublimation growth according to the present invention and having the SiC seed crystal shown in Fig. 2 arranged inside to be used as a seed crystal;
**Fig. 4** is a diagrammatic, cross-sectional view of the growth arrangement shown in Fig. 3 in a subsequent production stage after back-etching of the protective oxide layer from the SiC seed crystal and before starting a sublimation growth process;
**Fig. 5** is a diagrammatic, cross-sectional view of the growth arrangement shown in Fig. 4 during a subsequent production stage, which is a sublimation growth stage in which a bulk SiC single crystal is grown onto the SiC seed crystal after the protective oxide layer has been removed; and

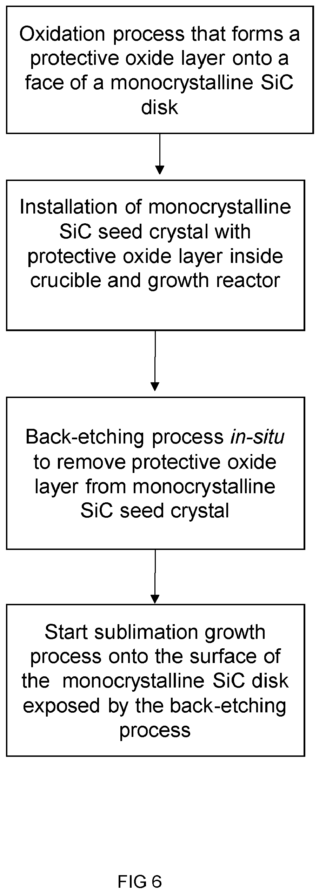

**Fig. 6** is a flowchart showing a sequence of steps performed by the method for producing a bulk SiC single crystal by sublimation growth according to the present invention.

### DETAILED DESCRIPTION OF THE INVENTION

The present invention will now be more fully described hereinafter with reference to the accompanying drawings, in which exemplary embodiments of the invention are shown. The present invention may, however, be embodied in many different forms and should not be construed as limited to the embodiments set forth herein. Rather, these embodiments are provided so that the disclosure will be thorough and complete, and will fully convey the scope of the invention to those skilled in the art. Like numbers refer to like elements throughout.

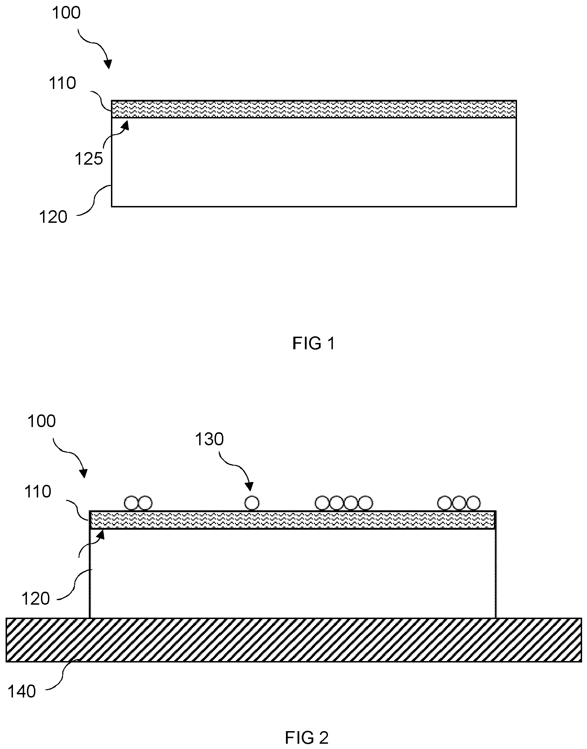

Referring to Fig. 1, a SiC seed crystal 100 with a protective oxide layer 110 according to the present invention is shown. The SiC seed crystal 100 has a monocrystalline silicon carbide disk 120 in which a first face 125, which is the face onto which the bulk SiC crystal is intended to be grown, is covered entirely (or partially) by the protective oxide layer 110. The function of the protective oxide layer 110 is to create a temporary protective surface onto which all the impurities and contaminating particles 130 from the external environment can adhere and that would otherwise inevitably fall onto to the deposition face 125 of the monocrystalline SiC disk 120 during preparations for the subsequent growth process, such as when fixing the seed crystal to a holding device 140. The SiC seed crystal 100 of the present invention allows to trap the impurities and contamination particle 125 onto the protective oxide layer 110, as depicted in Fig. 2. As the protective oxide layer 110 is intended to be removed prior to the start of the actual sublimation growth process, i. e. prior to the start of the deposition of SiC on the seed growth surface, but only after the SiC seed crystal 100 with the protective oxide layer 110 has been introduced into a growth crucible, a monocrystalline SiC layer seed with a deposition surface 125 free from impurities may be achieved.

The protective oxide layer 110 is preferably made from an oxide material, such as silicon dioxide, since this material can be easily removed by back-etching processes, such as those described later. In order to efficiently remove the protective oxide layer 110 in an homogeneous manner over the entirety of the covered face 125 during a single back-etching process, the protective oxide layer 110 is formed onto the monocrystalline SiC layer 110 by a suitable oxidation process and using selected parameters that allow to achieve an homogenous oxide thickness over the entire area 125 covered by the oxide layer 110. In particular, the protective oxide layer 110 is formed with a thickness variation along the covered area on the face 125 that is of less than a predetermined tolerance value, above and below, with respect to a mean thickness of the protective oxide layer. Here, the mean thickness corresponds to an average of the protective oxide layer thicknesses over the entire area covered by the protective oxide layer. Thus, the thickness of the protective oxide layer does not deviate by more than the predetermined tolerance value, above and below, the mean thickness at any position on the area of the first face 125 covered by the protective layer 110.

The SiC disk 120 is preferably made of SiC of the 4H modification. However, the SiC disk 120 may also be made from any one of the other SiC structural modifications (polytypes), such as the 6H, 15R, and 3C modifications of silicon carbide. The deposition surface 125 of the e.g. cut off SiC disk 120 corresponds preferably to the (000-1) crystal face (i.e. the C-face for PVT growth of 4H SiC bulk crystals), which is a preferred crystal face of seed substrates used in the semiconductor industry for growth of SiC bulk crystals by PVT. In addition, depending on the PVT properties required for the subsequent crystal growth, the monocrystalline SiC disk 120 may be cut and/or processed such that the crystallographic axis of the c-plane is tilted by an off-axis orientation from a direction perpendicular to the growth surface 125 of the monocrystalline SiC disk 120. Preferably, the off-axis orientation of SiC disk 120 is characterized by an off-axis angle between 0 and 4°.

The cut off monocrystalline SiC disks 120 may then be processed by processing steps commonly used in the field (in combination of all or individual processes) such as grinding, lapping and polishing (by mechanical and/or chemo-mechanical means) of the front and/or back sides of the SiC disk 120 to remove scratches, surface defects and sub-surface damages. In order to form an homogeneous oxide layer 110 thereon, the SiC disk 120 is preferably processed to yield a smooth deposition surface 125 with a surface roughness between 0.5 nm and 1 nm in the thickness direction of the SiC layer 120, which has preferably a thickness between about 500 µm and about 5000 µm as mentioned above. A chamfer may also be added to the front and back sides of the cut SiC disk 120. Alignment notches or flats may be also defined. The SiC disks 120 have preferably a substantially round disc shape, except for the presence of particular marks, such as the alignment notches and flats, and possess sufficient mechanical stability to be self-supporting. The so-prepared SiC disk 120 is intended to meet the industrial requirements for producing semiconductor SiC bulk crystals.

Conventionally, the so-processed monocrystalline SiC disk 120 with ideal properties of the deposition surface 125 would be subjected to further operations, such as fixing to the holding device 140 for holding the seed in the growth crucible, to make it usable as a seed crystal for growing SiC bulk single crystals thereon. However, since these operations cannot be carried out in clean rooms due to the high concentration of dust, particles and other impurities generated into the atmosphere during these handling operations, the ideally prepared surface 125 of the SiC disk 110 is in general contaminated again with metallic and/or non-metallic impurity atoms, inorganic or organic impurities or particles during these operations.

A concept underlying the present invention for preserving the ideal properties of the deposition surface 125 of the SiC seed crystal 120 until the deposition of SiC on the seed growth surface 125 begins, thus relies in forming a temporary protective oxide layer 110 on top of the SiC disk 120, i.e. on the deposition surface 125. More specifically, oxidation of the deposition surface 125 is performed immediately following the processing of the SiC slice 120 described above so that the protective oxide layer 110 is created before any dirt, impurity atoms, or particles can accumulate by physisorption or chemisorption on the ideal surface 125 of the SiC slice 120 during further handling of the seed.

For instance, the SiC substrate 100 with protective oxide layer 110 may be produced as follows. Firstly, a single-crystal slice or disk 120, preferably with a thickness between about 500µm and about 5000µm, is cut off from a bulk SiC single crystal of high quality, for e.g. by sawing or laser-assisted cutting, generally in a direction perpendicular to the longitudinal axis of the bulk SiC single crystal or tilted by a given off-axis angle. The cut off SiC disks 120 will have already a high crystalline quality with a low density of inclusions, dislocations and/or micro-tubes and a low content of impurity polytypes, so that a further treatment process for reducing the negative impact of existing defects on the subsequent crystal growth, such as by the treatment process described in JP 2008 024 554, no longer leads to significant improvements in the quality of the crystal to be grown on the seed. For instance, before application of the oxide layer 110, the monocrystalline silicon carbide disk 120 may have an etch pit density of less than 12000/cm², preferably less than 8000/cm², and/or a screw dislocation density of less than 2000/cm², preferably less than 1000/cm².

For the oxidation process, the SiC slice (or disk) 120 may be placed in a conventional oxidation chamber. For instance, the SiC slice 120 may be placed in a sealed chamber with inlets and outlets for supplying oxidation components and submitted to a controlled oxidation treatment by setting and maintaining a oxidation atmosphere with a suitable composition and under controlled pressure and temperature. In the oxidation chamber, the gas or chemical composition of the oxidation atmosphere may be controlled, as well as the setting of temperature, atmosphere pressure and oxidation process time. Thus, a protective oxide layer of a desired composition and thickness, namely, with a uniform and homogeneous thickness, may be achieved. For instance, an oxide layer with a thickness between 1 nm and 25 nm (measured on the crystalline C-face of the SiC disk 120) may be achieved using such a controlled oxidation process and which is suitable for being easily removed by the subsequent back-etching process. Several oxidation processes known in the field may be used for forming the protective oxide layer 110 according to the present invention onto a monocrystalline SiC disk 120. For instance, one or more of the following processes (alone or in combination) may be used:
(i) dry oxidation with oxygen and optionally an inert gas, the inert gas including nitrogen and/or argon;
(ii) wet oxidation with a mixture of oxygen and water and optionally an inert gas;
(iii) oxidation at a room temperature between 15°C and 50 °C in a defined gas atmosphere;
(iv) oxidation by ozone;
(v) oxidation by oxygen plasma; and/or
(vi) oxidation with at least one of Na₂CO₃, H₂O₂, NaOH, KIO₃, KCIO₃, KMnO₄, and CrO₃.

The temperature, pressure and/or process time parameters for achieving the desired final oxide thickness may be determined by experimentation and/or simulation analysis depending on the specific composition of the oxide layer to be formed 110, oxidation atmosphere and characteristics of the oxidation chamber to be used, such as chamber volume and associated heating and pressure systems.

The preparation of an homogeneous oxide layer with a small variation in thickness over the entire covered area 125 of the SiC disk 120 is an important factor to ensure that the ideal surface 125 of monocrystalline SiC layer 120 becomes entirely exposed for crystal growth after removal of the oxide layer 110 by back-etching.

Measurement of the oxide layer thickness may be performed non-destructively after the end of the oxidation process, for e.g. by ellipsometry. Advantageously, the thickness measurement may be made *in-situ* (i.e. with the SiC disk 120 inside the oxidation chamber) with a suitable design of the oxidation chamber. This also allows to terminate the oxidation process once the desired thickness of the oxide layer 110 according to the invention is reached.

The monocrystalline SiC disk 120 and more particularly, the surface 125 intended to be used for crystal growth, is thus protected from dirt, adsorption of impurity atoms and particles during the handling process steps, such as fixation to the holding device and/or installation in the growth crucible, which have to be performed prior to starting the deposition of SiC on the seed growth surface for growing the bulk SiC single crystal.

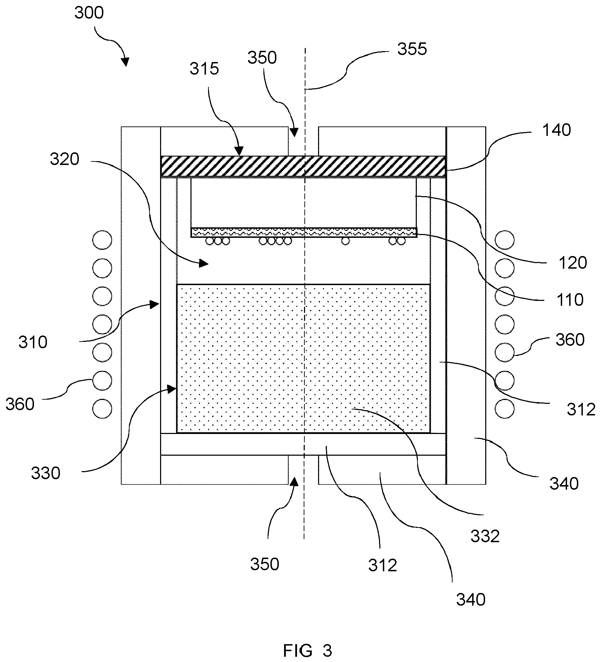

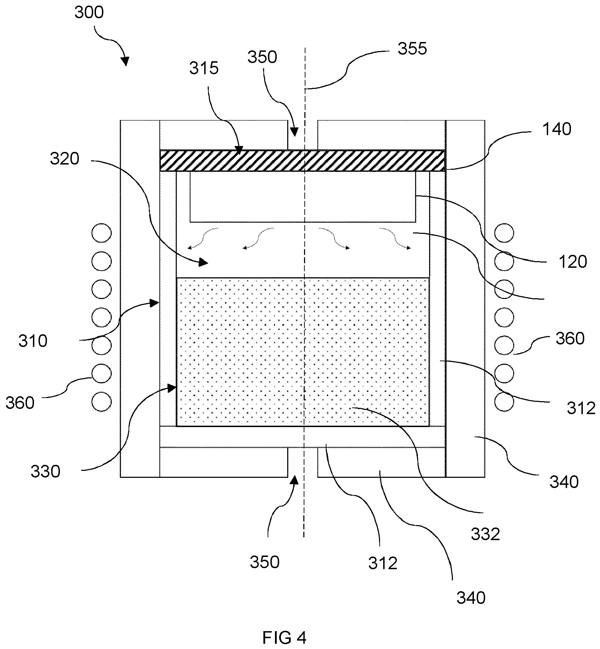

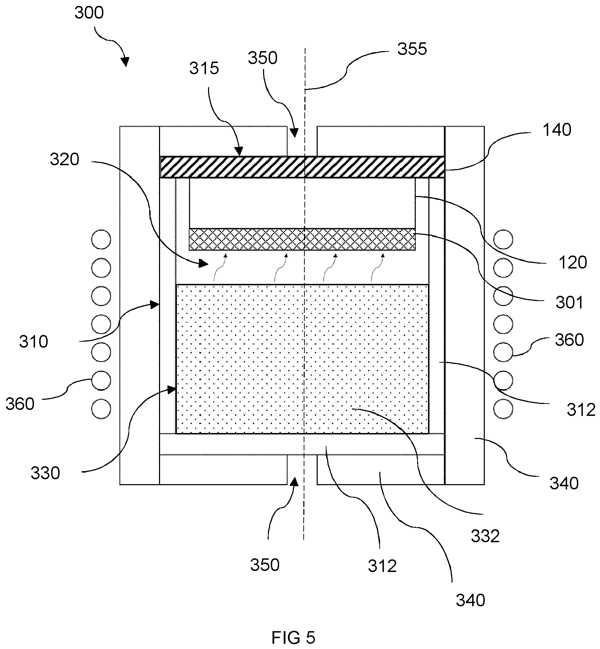

A method for producing at least one SiC bulk single crystal using the SiC substrate 100 using the SiC substrate 100 according to the present invention as a seed crystal for sublimation growth will now be described with reference to Figs. 3 - 5.

Fig. 3 shows an embodiment of a crystal growth arrangement 300 for producing a bulk SiC single crystal 301 by a sublimation growth process according to the present invention. The growth arrangement 300 includes a crystal growth crucible 310 within which the SiC seed crystal 100 is inserted to produce a bulk SiC single crystal by means of sublimation (also called physical vapour transport). Specifically, the growth crucible 310 is provided with a crystal growth region 320 inside which a seed crystal, such as the SiC seed crystal 100 described above, is arranged and a source material region 330 which stores the source material 332, such as silicon carbide in powdered, compacted, or partly compacted form, and which is to be sublimated during a sublimation growth process. For instance, the SiC powder may be poured into the source material region 314 as a pre-finished starting material before the beginning of the sublimation growth process. The seed crystal 100 fixed to the crucible lid 315 (which in the present example serves as the holding device 140) and arranged inside the crucible 310 so as to be disposed facing and opposed to the SiC source material region 330. Generally, the diameter of the seed crystal 100 is selected to be approximately of a same diameter as the bulk SiC single crystal to be grown thereon. Nonetheless, the diameter of the final bulk SiC single crystal diameter may be smaller or larger than the underlying seed crystal 100 by a small deviation, such as by less than 30%. In particular, for normal wafer crystal growth the diameter of the seed crystal is equal or larger than the grown bulk crystal. However, the fabrication of bulk crystals may also be used for producing new, larger seed crystals. For such a diameter enlargement, the seed crystal is smaller than the grown bulk crystal.

The walls 312 and lid 315 of the growth crucible 310 enclose the crystal growth region 320 and source material region 330 to allow creation of a controlled sublimation atmosphere in the crystal growth region 320. The growth crucible 310 is preferably made of an electrically and thermally conductive graphite crucible material with a density of, for example at least 1.75 g/cm³. The growth arrangement 300 also includes a thermal insulation enclosure 340 which is placed around the growth crucible 310 after insertion of the seed crystal 100 in the growth region 320 and/or storage of the SiC source material 332 in the source material region 330. The thermal insulation enclosure 340 may consist in a thermal insulation sheet or casing made of a foam-like graphite insulation material of fibre isolation material, preferably having a higher porosity than that of the graphite material forming the walls 312 and lid 315 of the crucible 310, so as to provide an improved thermal insulation. Additional openings or inlets 350 may be also provided in the top and bottom of the thermal insulation enclosure 340, preferably arranged about a longitudinal central axis 355 of the crucible 310. The transportation of the gaseous species out of or into the growth region 320 is thereby limited by the density of the dense graphite.

The growth arrangement 300 is then arranged inside a reactor chamber (not shown), which is conventionally configured as a tubular container, such as a quartz glass tube, surrounded by respective cooling and heating systems for generating and controlling the temperature gradients needed to sublimate the source material and transport the sublimated components towards the seed crystal 120 during the sublimation growth process. For instance, the heating means may be provided as an inductive heating coil 12 associated with a controlled current to produce a desired temperature inside the crucible 310 by inducing an electrical current that circulates in the electrically conductive walls 312 of the growth crucible 310 around the central axis 355. Growth temperatures of more than 2000° C, and in particular, of about 2400° C may be achieved during the sublimation process under a growth pressure between 0.1 mbar and 100 mbar.

During the sublimation growth process, the SiC material is sublimated from the source material region 330 by the induced heat and the sublimated gaseous components transported into the crystal growth region 320 under the effect of the thermal gradients generated inside the crucible 310. A SiC growth gas phase is therefore generated in the crystal growth region 320 and from which the bulk SiC single crystal grows onto the seed crystal by means of deposition from the SiC growth gas phase.

The growth crucible 310 illustrated in Figs. 3 - 5 is designed to grow one bulk SiC single crystal at a time. However, the SiC seed crystal 100 and method of producing a bulk SiC crystal using the SiC seed crystal 100 according to the principles of the present invention are also intended to be applied to growth crucibles having a plurality of growth regions designed for growing more than one bulk SiC single crystal simultaneously. For instance, it is envisaged to use a growth crucible having a source material region provided in a central region of the crucible and two crystal growth regions arranged on opposed sides of the source material region for accommodating respective seed crystals therein and grow two bulk SiC crystals at the same time from the same source material.

As mentioned above, in the method for producing at least one bulk SiC single crystal by means of sublimation growth according to the present invention, prior to the start of the sublimation growth process a protective oxide layer 110 is first deposited onto the deposition face 125 of the monocrystalline SiC disk 120 before fixing it to the holder device for preserving the high quality of the deposition face 125, such as the (000-1) (i. e. Carbon) face in case of 4H crystal growth. Thus, the deposition face 125 is temporarily protected against deposition of impurity atoms, particles, and impurities. The SiC seed crystal 100 is then fixed to a holding device or crucible lid 315, powdered or (partly) compacted SiC source material is arranged in the source material region 330, and the growth crucible 310 covered with the thermal insulation enclosure 340 inserted into a reactor chamber.

The protective oxide layer 110 with impurity atoms, impurities and particles adsorbed thereon is subsequently removed *in-situ* (i.e. inside the crucible 310, after the SiC seed crystal 100 has been arranged inside the growth crucible 310 and the growth arrangement 300 inserted in the reactor chamber) by performing a back-etching process before starting crystal growth by sublimation. Specifically, a back-etching process is performed which may include setting a vapor pressure of a gaseous atmosphere of back-etching components in the crystal growth region 320. In particular, a temperature gradient is required which favors the dissolution of silicon dioxide compared to the deposition of SiC. Consequently, silicon dioxide evaporates before SiC is deposited.

For instance, back-etching may be achieved by setting a lower vapor pressure of etching species, such as carbon, in the atmosphere of the growth region 320 where the SiC substrate 100 is located. This etching atmosphere sublimates away the previously generated protective oxide layer 110 including all contamination atoms, particles and impurities that may have been deposited thereon.

The composition of the back-etching gaseous atmosphere and respective pressure are selected depending on the composition of the protective oxide layer 110 so as to entirely etch the oxide material away from the SiC substrate 100. In particular, several back-etching processes and conditions may be used for removing *in-situ* the protective oxide layer 110 from the SiC seed crystal 100. For example, a back-etching process may be performed by setting a pressure between 1 mbar and 100 mbar and/or by setting a nucleation temperature between 1200°C and 1400°C, or between 1650°C and 1850°C. Back-etching can also be performed under high vacuum or during purging with inert gas, such as argon. Furthermore, reducing gases such as SF₆, Cb, CHF₃, C₂F₆, NF₃, CF₄, or mixtures thereof can be introduced into the growth crucible 310 to selectively remove the oxide layer 110 and thus the impurity atoms, particles, and impurities located thereon. Finally, several of the above variants for the back-etching process may be combined.

The back-etching process is then maintained during a time duration that depends on parameters such as thickness and composition of the protective oxide layer, reactivity of the back-etching gaseous atmosphere, and the like, such as to entirely expose the area of the deposition face 125 of the monocrystalline SiC disk 120 previously covered by the protective oxide layer 110. Thus, by setting a suitable etching vapor pressure in the growth region 320 prior to the start of the sublimation growth, i. e. the deposition of SiC on the growth surface, the protective oxide layer 110 temporarily formed on the SiC seed crystal 100 may be efficiently removed, thereby exposing the ideally prepared face 125 (which is the C-face in the present example) of the underlying monocrystalline SiC disk 120 without further impurities, impurity atoms or particles. As a result, it is possible to subsequently start the sublimation growth of a bulk SiC single crystal onto the exposed surface 125 of the monocrystalline SiC disk 120, without additional handling operations of the monocrystalline SiC disk 120 and more importantly, without having to remove the monocrystalline SiC disk 120 from the growth crucible 310 and expose it to contamination agents. It is then possible to produce a bulk SiC single crystal with high quality and very low concentration of defects.

In summary, the present invention allows to preserve the ideal properties of a monocrystalline SiC disk 120 to be used as a seed crystal, and in particular, the properties for PVT growth of the C-face of a 4H-SiC disk, against the negative effects caused by impurity particles and contaminants deposited on the surface 125 intended for crystal growth by means of a temporary protective oxide layer which is formed onto the seed crystal face 125 immediately after the end of the cutting and polishing processes which the monocrystalline SiC disk 120 undergoes in preparation for subsequent crystal growth processes. The protective oxide layer 110 remains on the top of the SiC seed crystal 100 until shortly before the start of the crystal growth, namely the deposition of SiC, and at least until after installation of the SiC seed crystal 100 inside the crystal growth crucible 310. Consequently, the deposition of dirt, particles and impurity atoms during handling operations of the SiC seed crystal 100, such as fixing and inserting it into the growth crucible 310, that act as sources for creating new crystal defects in the grown crystal can be eliminated.

Further, since the production method of bulk SiC single crystal(s) of the present invention is designed in such a way that the protective oxide layer 110 is removed *in-situ* before beginning growing the bulk SiC single crystal growth onto the seed crystal, crystal growth can be readily initiated on the ideal surface 125 of the monocrystalline SiC disk 120 which is part of the seed crystal 100, i.e. free from impurities, particles, impurity atoms. Thus, a bulk SiC single crystal with high quality can be produced.

Although certain features of the above exemplary embodiments were described using terms such as "top", "bottom", and "upper", these terms are used for the purpose of facilitating the description of the respective features and their relative orientation within the optical module only and should not be construed as limiting the claimed invention or any of its components to a particular spatial orientation. Moreover, in the above disclosure, where the terms "about" or "approximately" were applied to a particular value or to a range, this is to be understood as referring to a value or range which is as accurate as the method used to measure it. For instance, in case no measurement errors are mentioned, the expression "about 500 µm" is to be construed as referring to a value having the same round-off as "500 µm".

### Reference Signs

- 100: SiC seed crystal
- 110: Protective oxide layer
- 120: Monocrystalline SiC disk
- 125: Deposition face of SiC disk
- 130: Impurities
- 140: Holding device

- 300: Growth arrangement
- 301: Bulk SiC crystal
- 310: Crystal growth crucible
- 312: Crucible walls
- 315: Crucible lid
- 320: Crystal growth region
- 330: Source material region
- 340: Thermal insulation enclosure
- 350: Openings
- 355: Central axis
- 360: Heating coil

## Claims

1. Silicon carbide seed crystal (100), comprising:
a monocrystalline silicon carbide disk (120); and
a protective oxide layer (110) covering an area of a first face (125) of the monocrystalline silicon carbide disk (120);
wherein the protective oxide layer (110) is **characterized by** having a thickness variation along the covered area that is of less than a predetermined tolerance value, above and below, from a mean thickness of the protective oxide layer (110).

2. Silicon carbide seed crystal (100) according to claim 1, wherein:
said mean thickness is an average of the protective oxide layer thicknesses over the entire area covered by the protective oxide layer (110); and/or
the mean thickness of said protective oxide layer (110) is from 5 nm to 20 nm.

3. Silicon carbide seed crystal (100) according to claim 1 or 2, wherein
the protective oxide layer (110) is composed of silicon dioxide and has a mean thickness of 1 nm to 25 nm, the predetermined tolerance value is 0.5 nm so that the thickness of the protective oxide layer at any position of the covered area of the first face does not deviate by more than 0.5 nm, above or below, the mean thickness of the protective oxide layer.

4. Silicon carbide seed crystal (100) according to any one of claims 1 to 3, wherein
the deviation of the thickness of the protective oxide layer (110) is not more than 0.3 nm, above or below, the mean thickness.

5. Silicon carbide seed crystal (100) according to any one of claims 1 to 4, wherein:
the first face (125) covered by the protective oxide layer (110) corresponds to a C-face of the monocrystalline silicon carbide disk; and/or
the monocrystalline silicon carbide disk (120) has a thickness between 500µm and 5000µm, or between 800µm and 3000µm; and/or
the silicon carbide disk (120) has a diameter greater than or equal to 150 mm, preferably greater than or equal to 200 mm.

6. Silicon carbide seed crystal (100) according to any one of claims 1 to 5, wherein
the first face of the monocrystalline silicon carbide disk (120) has a surface roughness between 0.5 nm and 1nm in the direction of the monocrystalline silicon carbide disk thickness.

7. Silicon carbide seed crystal (100) according to any one of claims 1 to 6, wherein:
the monocrystalline silicon carbide disk (120) is made of one of the 4H-, 6H-, 15R-, and 3C-modifications of silicon carbide, preferably pf the 4H-SiC modification; and/or
the monocrystalline silicon carbide disk (120) has an off-axis orientation **characterized by** an off-axis angle between 0° and 4°, preferably a 0° to 2° off-axis orientation

8. Silicon carbide seed crystal according to any one of claims 1 to 7, wherein the first face (125) of the monocrystalline silicon carbide disk (120) has:
an etch pit density of less than 12000/cm², preferably less than 8000/cm²; and/or
a screw dislocation density of less than 2000/cm², preferably less than 1000/cm².

9. Method of producing at least one bulk silicon carbide single-crystal (301) by sublimation growth inside a growth crucible having at least one crystal growth region (320) for arranging at least one seed crystal (100) inside and a source material region (330) in which powdered or partly compacted silicon carbide material is stored for sublimation, the method comprising steps of:
providing at least one silicon carbide seed crystal (100) with a protective oxide layer (110) according to any one of claims 1 to 8 to be used as the at least one seed crystal;
fixing the at least one seed crystal (100) to a holding device and inserting the seed crystal (100) fixed to the holding device into the growth region of the growth crucible;
enclosing the growth crucible with a thermal insulation material;
performing a sublimation growth process during which the source material is sublimated from the source material region and the sublimated gaseous material transported into the crystal growth region to generate a silicon carbide growth gas phase in the crystal growth region from which a bulk silicon carbide single-crystal is grown onto the seed crystal arranged therein by deposition from the SiC growth gas phase;
**characterized by** the following step:
after the at least one seed crystal (100) with the protective oxide layer (110) is arranged in the crystal growth region and before starting the sublimation growth process, performing a back-etching process in the crystal growth region that is adapted to remove the protective oxide layer from the surface of the seed crystal and to expose the underlying monocrystalline silicon carbide disk (120).

10. Method according to claim 9, wherein
said step of providing at least one silicon carbide seed crystal (100) with a protective oxide layer (110) includes:
performing an oxidation process onto a monocrystalline silicon carbide disk for covering said area on the first face with an oxide layer,
wherein the oxidation process is performed prior to fixing the silicon carbide seed crystal to a holding device and inserting the silicon carbide seed crystal fixed to the holding device into the growth region of the growth crucible.

11. Method according to claim 9 or 10, wherein
the at least one silicon carbide seed crystal (100) used as the crystal seed is provided with the first face corresponding to a growth surface of the monocrystalline silicon carbide disk; and/or
the growth crucible used in the producing method is partly formed of graphite.

12. Method according to any one of claims 9 to 11, wherein:
the back-etching process comprises:
supplying a gaseous atmosphere of back-etching components to the crystal growth region in the growth crucible, and setting a given vapor pressure of the back-etching gaseous atmosphere that is selected to etch away the protective oxide layer, wherein the back-etching components comprise silicon and/or carbon; and
maintaining the back-etching process for a time duration that depends on the thickness of the protective oxide layer such as to entirely expose the area of the first face covered by the protective oxide layer.

13. Method according to any one of claims 9 to 12, wherein
the back-etching process is performed under one of the following conditions or a combination thereof:
(i) at a pressure between 0.1 mbar and 100 mbar;
(ii) during a high vacuum process step at a pressure in the range of 1×10⁻⁷ mbar to 1×10⁻³ mbar;
(iii) during a purging process step with an inert gas; and
(iv) by using a reducing gas selected from a group of reducing gases that include SF₆, Cb, CHF₃, C₂F₆, NF₃, CF₄, or mixtures thereof in the growth crucible.

14. Method according to any one of claims 9 to 13, wherein
the back-etching process is performed under one of the following temperature conditions:
(i) at a temperature above 1200°C and below the sublimation temperature of the source material, preferably below 1400°C; and
(ii) at a temperature above 1650°C and below the sublimation temperature of the source material, preferably below 1850°C.

15. Method according to any one of claims 8 to 13, wherein
the oxidation process includes one of the following processes or a combination thereof:
(i) dry oxidation with oxygen and optionally an inert gas, the inert gas including nitrogen and/or argon;
(ii) wet oxidation with a mixture of oxygen and water and optionally an inert gas;
(iii) oxidation at a room temperature between 15°C and 50°C in a defined gas atmosphere;
(iv) oxidation by ozone;
(v) oxidation by oxygen plasma; and/or
(vi) oxidation with at least one of Na₂CO₃, H₂O₂, NaOH, KIO₃, KCIO₃, KMnO₄, and CrO₃.
